# EUROPÄISCHE PATENTSCHRIFT

(11) **EP 2 134 989 B1**
(45) Veröffentlichungstag und Bekanntmachung des Hinweises auf die Patenterteilung: **18.06.2014**
(21) Anmeldenummer: 08718113.7
(22) Anmeldetag: 20.03.2008
(51) Int. Cl.: F16H 59/70, F16H 63/38, H01H 13/28, H03K 17/96

(54) **TASTERANORDNUNG ZUR ERFASSUNG DER SCHALTSTELLUNG EINES GETRIEBES SOWIE GETRIEBE MIT DER TASTERANORDNUNG**
SENSOR ARRANGEMENT FOR DETECTING THE GEAR POSITION OF A TRANSMISSION, AND TRANSMISSION HAVING THE SENSOR ARRANGEMENT
ENSEMBLE PALPEUR POUR DETECTER LA POSITION DE CHANGEMENT DE VITESSE D'UNE BOITE DE VITESSES, ET BOITE DE VITESSES POURVUE DE L'ENSEMBLE PALPEUR

(30) Priorität: 07.04.2007 DE 102007016751
(43) Veröffentlichungstag der Anmeldung: 23.12.2009
(73) Patentinhaber: Schaeffler Technologies GmbH & Co. KG, 91074 Herzogenaurach (DE)
(72) Erfinder: OBERPERTINGER, Gerhard, 91325 Adelsdorf (DE)
(86) Internationale Anmeldenummer: PCT/EP2008/053404
(87) Internationale Veröffentlichungsnummer: WO 2008/122501

(56) Entgegenhaltungen:
- EP-A- 0 732 715
- DE-U1-202005 009 485

## Beschreibung

### Gebiet der Erfindung

Die Erfindung betrifft eine Tasteranordnung zur Erfassung der Schaltstellung eines Getriebes durch Auslesen einer Höhenkodierung einer Schaltwelle, mit einem Gehäuse, mit einem Tastelement, welches in dem Gehäuse in seiner axialen Erstreckungsrichtung verschiebbar angeordnet und/oder ausgebildet ist, wobei eine Tastspitze des Tastelements auf der Schaltwelle bzw. der Höhenkodierung tastend aufliegt und/oder auflegbar ist, so dass das Tastelement entsprechend der Höhenkodierung der Schaltwelle in verschiedene Auslesezustände überführt wird, die sich durch die axiale Lage des Tastelements unterscheiden, und mit einer Sensoreinheit zur Erfassung des Auslesezustands des Tastelements sowie ein Getriebe mit dieser Tasteranordnung.

### Hintergrund der Erfindung

Derartige Tasteranordnungen werden bei Getrieben eingesetzt, um deren Schaltstellung zu erfassen und diese zum einen einem Fahrer als Information anzuzeigen und zum anderen bei bestimmten Schaltstellungen des Getriebes, automatisiert Vorgänge ablaufen zu lassen. Beispielsweise werden über derartige Tasteranordnungen die Rückfahrleuchten eines Fahrzeuges angesteuert, sobald die Tasteranordnung das Einlegen eines Rückwärtsgangs als Schaltstellung erfasst.

Die Druckschrift EP 1 063 450 beschreibt beispielsweise eine Wegemess- und Kontrolleinrichtung für Kraftfahrzeuggetriebe mit einer Schaltwelle, wobei die Schaltwelle in Achsrichtung verschiebbar und um ihre Achse drehbar angeordnet ist, um Gassen anzuwählen und Gänge einzulegen. Auf einem freien Ende der Schaltwelle ist ein Messelement mit einer Messfläche angeordnet, wobei die Messfläche gewinkelt und nicht-senkrecht zu der Längserstreckung der Schaltwelle ausgerichtet ist. Auf der Messfläche liegt ein verstellbares Abtastelement an, das mit einer Messeinrichtung zusammenwirkt, indem die Messeinrichtung anhand der Position des Abtastelements die Schaltstellung der Schaltwelle bestimmt.

Die Druckschrift EP 1 350 991 B1 beschreibt eine Sensoranordnung zur Bestimmung der Schaltwalzenstellung, wobei ein Taster eine konturierte Umfangsfläche einer mit einer Schaltwelle fest verbundenen Sensorscheibe abtastet und durch berührungslose Messung der Position des Tasters mittels eines Hall-Elements die Schaltstellung bestimmt.

Die Druckschrift EP 1 152 174 A2 beschreibt ebenfalls eine Sensoranordnung zur Bestimmung der Schaltstellung, wobei die Schaltwelle in Umfangsrichtung verlaufende, nutähnliche Vertiefungen aufweist, die von einem Taster der Sensoranordnung abgetastet werden. In Abhängigkeit der Schaltstellung sind die nutähnlichen Vertiefungen verschieden tief ausgebildet, so dass durch Auslesen der Position des Tasters die Schaltstellung der Schaltwelle bestimmt wird. Das Auslesen der Position des Tasters erfolgt über einen berührungslosen Näherungssensor.

Die Druckschrift US 5,717,180 betrifft eine weitere Ausbildung einer Tasteranordnung zur Erfassung der Schaltstellung eines Getriebes und bildet wohl den nächstkommenden Stand der Technik. Bei dieser Tasteranordnung fährt ein Tastelement eine konturierte Oberfläche einer Schaltwelle ab, wobei die Konturierung der Schaltwelle eine Kodierung der Schaltstellung darstellt. Der axiale Versatz des Tastelements wird über einen teleskopartigen Federmechanismus an einen Stempel weitergeleitet, welcher eine Membran auslenkt. Die Auslenkungsposition der Membran wird durch einen Schalter detektiert, welcher genau zwei Schaltzustände (offen/geschlossen) einnehmen kann. Somit beruht auch diese Tasteranordnung auf einer Weg- bzw. Positionsmessung des Tastelements.

DE 20 2005 009 485 U1 zeigt gattungsgemäß ein Arretierelement, das einen Stößel aufweist, über den Zungen als elektrische Einzelkontakte betätigbar sind. Der Stößel wirkt somit als Schalter für ein Öffnen bzw. Schließen der Kontakte. EP 0 732 715 A1 zeigt ein Arretierelement, dessen Stößel ebenfalls als Betätigungselement eines elektrischen Schalters dient. Die Genauigkeit der Positionsbestimmung ist begrenzt, es können nur diskrete Stellungen erkannt werden.

### Zusammenfassung der Erfindung

Der Erfindung liegt die Aufgabe zugrunde, eine Tasteranordnung zur Erfassung der Schaltstellung eines Getriebes sowie ein Getriebe mit der Tasteranordnung vorzuschlagen, wobei die Tasteranordnung konstruktiv einfach und störungssicher ausgebildet sein soll.

Diese Aufgabe wird durch eine Tasteranordnung mit den Merkmalen des Anspruchs 1 sowie mit einem Getriebe mit den Merkmalen des Anspruchs 15 gelöst. Bevorzugte oder vorteilhafte Ausführungsformen der Erfindung ergeben sich aus den abhängigen Ansprüchen, der nachfolgenden Beschreibung sowie den beigefügten Zeichnungen.

Erfindungsgemäß wird eine Tasteranordnung zur Erfassung der Schaltstellung eines Getriebes vorgestellt, wobei das Getriebe vorzugsweise als manuelles oder teilautomatisiertes Getriebe ausgebildet ist. Das Getriebe weist mindestens eine Schaltwelle auf, welche bei einem Schaltvorgang bewegt wird, insbesondere um die eigene Achse gedreht und/oder in Achsrichtung verschoben wird. Die Schaltwelle weist eine Höhenkodierung auf, welche vorzugsweise als Höhenkodierung längs der Schaltwelle ausgebildet und zum Beispiel als eine Abfolge von Nuten oder Vertiefungen und Scheiben oder Erhöhungen ausgebildet ist, oder als Höhenkodierung in Umfangsrichtung der Schaltwelle, ebenfalls mit Erhöhung und Vertiefung ausgestattet, oder mit einem angesetzten Messelement, welches die Höhenkodierung trägt bzw. umsetzt. Die Höhenkodierung ist zu Schaltstellungen bzw. Schaltzwischenstellungen des Getriebes referenziert, insbesondere derart, dass einer bestimmten Höhe der Höhenkodierung eine bestimmte Schaltstellung zugeordnet ist. Dadurch, dass die Tasteranordnung die Höhenkodierung der Schaltwelle in einer momentanen Posi tion ausliest, kann in Kenntnis der Höhenkodierung in einfacher Weise auf die aktuelle Schaltstellung geschlossen werden.

Die Tasteranordnung weist ein Gehäuse auf, welches ein- oder mehrteilig ausgebildet sein kann, und in dem ein Tastelement zumindest abschnittsweise angeordnet, insbesondere gelagert ist, welches in dem Gehäuse in axialer Erstreckung des Tastelements verschiebbar positioniert ist, wobei die axiale Erstreckung insbesondere der Messrichtung des Tastelements entspricht. Das Tastelement weist eine Tastspitze auf, die einstückig mit dem Tastelement verbunden sein kann, jedoch auch über Zwischenelemente mit dem Tastelement zusammenwirken kann, welche auf der Schaltwelle bzw. der Höhenkodierung tastend aufliegt, so dass das Tastelement entsprechend der Höhenkodierung der Schaltwelle in verschiedene Auslesezustände überführt wird, wobei sich die Auslesezustände durch die axiale Lage des Tastelements unterscheiden.

Zur Erfassung des Auslesezustands des Tastelements weist die Tasteranordnung eine Sensoreinheit auf, wobei - in Abgrenzung zum bekannten Stand der Technik - diese zur Detektion des Auslesezustands des Tastelements mittels einer Kraft- und/oder Druckmessung ausgebildet ist. Insbesondere ist die Sensoreinheit als Druck- und/oder Kraftsensor realisiert, wobei aufgrund des physikalischen Zusammenhanges Druck = Kraft / Fläche vorzugsweise jeder Drucksensor auch als Kraftsensor eingesetzt werden kann.

Die Erfindung geht von der Überlegung aus, dass bei den bekannten Tasteranordnungen die Sensoreinheiten stets den Auslesezustand des Tastelements auf Basis einer Positionsbestimmung ermitteln. Dies führt jedoch dazu, dass auch im Bereich der Sensoreinheit bewegbare Komponenten der Tasteranordnung vorgesehen sein müssen, welche in ungünstigen Fällen verklemmen oder zu anderen Funktionsausfällen führen können. Demgegenüber schlägt die Erfindung vor, statt einer Wegmessung eine Kraft- bzw. Druckmessung durchzuführen, so dass sich optional der Vorteil ergibt, dass im Bereich der Sensoreinheit nur noch Komponenten platziert sind, welche sehr geringe Verfahrbewegungen durchführen müssen, die Sensoreinheit zugleich jedoch eine hohe Präzision aufweist. Durch die positions- oder wegmessfreie Detektion des Auslesezustands des Tastelements wird somit die Zuverlässigkeit und die Gesamtlebensdauer der Tasteranordnung deutlich verbessert.

Prinzipiell ist es möglich, dass die Tasteranordnung ausgebildet ist, nur einen einzigen, definierten Auslesezustand, insbesondere eine definierte Hub-Position des Tastelements zu detektieren. Es ist jedoch bevorzugt, wenn die Tasteranordnung ausgelegt ist, um mehrere definierte Auslesezustände, insbesondere Hub-Positionen des Tastelements zu detektieren. Vorzugsweise erlaubt die Sensoreinheit eine mehrstufige, insbesondere mindestens zwei- oder mindestens dreistufige, eine quasi-stufenlose, mit auflösungsbedingten Abstufungen, und/oder eine stufenlose Messung der Kraft bzw. des Drucks. Zum einen ermöglichen diese Ausführungen, dass mehrere verschiedene Schaltstellungen sowie Schaltzwischenstellungen detektiert werden, zum anderen gestatten diese Ausbildungen eine einfache, zum Beispiel software-gestützte oder elektronische Kalibrierung der Tasteranordnung.

Bei einer bevorzugten Ausführungsform sind das Tastelement und die Sensoreinheit zur Detektion des Auslesezustands über ein elastisches Übertragungsmittel miteinander verkoppelt. Somit wird die axiale Bewegung des Tastelements über das elastische Übertragungsmittel in eine Federkraft bzw. einem daraus resultierenden Federdruck umgesetzt, welche bzw. welcher auf eine Messfläche der Sensoreinheit wirkt. Durch die axiale oder lineare Hubbewegung des Tastelements wird das elastische Übertragungsmittel gestaucht, wodurch sich die Rückstellkraft des elastischen Übertragungsmittels erhöht. Nachdem sich die Kraftänderung zumindest im Bereich des Hook'schen Gesetzes nahezu direkt proportional zur linearen Hubbewegung des Tastelements verhält, kann über die Kraft- und/oder Druckmessung der Sensoreinheit in einfacher Weise auf den Auslesezustand des Tastelements geschlossen werden. Von der Erfindung umfasst ist auch ein elastisches Übertragungsmittel, wie es zum Beispiel in der Druck US 5,717,180 in Form eines gefederten, teleskopartigen Aufbaus vorgestellt wird, wobei die Offenbarung dieser Druckschrift via Referenzierung in die vorliegende Offenbarung übernommen wird.

Bei einer besonders praktikablen Ausgestaltung der Erfindung ist das elastische Übertragungsmittel als eine Feder, insbesondere eine Druckfeder ausgebildet. Vorzugsweise stützt sich die Feder mit ihrem einen freien Ende an dem Tastelement und mit dem anderen freien Ende an der Sensoreinheit, insbesondere einer Messfläche der Sensoreinheit ab. Dieser konstruktive Aufbau erlaubt insbesondere, vorhandene Arretierungen mit einstellbarer Federvorspannkraft, wie sie bereits bei Getrieben für Kraftfahrzeugen eingesetzt werden, mit geringen Anpassungsarbeiten in eine erfindungsgemäße Tasteranordnung zu wandeln.

Bei einer Ausführungsalternative sind das Tastelement und die Sensoreinheit zur Detektion des Auslesezustands starr miteinander verkoppelt, wobei vorzugsweise vorgesehen ist, dass entweder die Höhenkodierung mit einer nur geringen absoluten Höhenänderung erfolgt, so dass der Hub des Tastelements gering ist, oder, dass die Sensoreinheit einen größeren Hubweg toleriert.

Bei einer konstruktiven Umsetzung der Tasteranordnung ist die Sensoreinheit als ein Drucksensor und/oder Kraftsensor ausgebildet, welcher die physikalische Größe Druck bzw. Kraft in eine zum Druck bzw. zu der Kraft abhängige, insbesondere proportionale elektrische Ausgangsgröße umwandelt. Vorzugsweise basiert die Sensoreinheit auf dem piezoelektrischen Effekt und ist insbesondere als ein piezo-elektrischer oder piezo-resistiver Messaufnehmer ausgebildet. Alternativ bevorzugt basiert die Sensoreinheit auf einem Messaufnehmer bei dem die Messgröße über die Signaländerung bei Längenänderung eines Messelements erfolgt und/oder ist als ein Sensor mit Dehnungsmessstreifen (DMS) ausgebildet. Damit kann die Sensoreinheit insbesondere als Halbleiter-/Folien- oder Draht-Dehnmessstreifen, piezoelektrischer Sensor, piezo-resistiver Drucksensor, piezo-elektrischer Drucksensor oder resistiver Folien-Drucksensor ausgebildet sein.

Bei einer Weiterbildung der Erfindung weist die Tasteranordnung eine Auswertevorrichtung auf, welche anhand der Kraft- und/oder Druckmessung bzw. der daraus resultierenden Signale die Schaltstellung des Getriebes erkennt. Insbesondere führt die Auswertevorrichtung eine Zuordnung der Auslesezustände des Tastelements zu den Schaltstellungen des Getriebes durch.

Besonders bevorzugt ist es, wenn die Auswertevorrichtung eine Schnittstelle für Steuerleitungen, insbesondere zur Ansteuerung eines Bauteils, z. B. eines Relais oder MOSFETs, zur Schaltung einer elektrischen Last, wie zum Beispiel eines Rückfahrlichts aufweist. Alternativ hierzu kann die Auswertevorrichtung und/oder die Tasteranordnung auch das Bauteil zur Schaltung der elektrischen Last umfassen.

Bei einer praktischen Realisierung der Erfindung ist das Gehäuse als ein in ein Getriebegehäuse des Getriebes einschraubbarer Grundkörper ausgebildet. Beispielsweise ist das Gehäuse zylinderförmig mit einem Außengewinde realisiert und weist zudem Mittel zum Ansetzen eines Werkzeugs auf, so dass das Gehäuse in das Getriebegehäuse eingeschraubt werden kann.

Ferner umfasst die Tasteranordnung vorzugsweise eine Abdeckkappe, welche auf das Gehäuse bzw. den Grundkörper lösbar befestigbar, insbesondere aufschnappbar oder aufschraubbar ist, wobei in der Abdeckkappe die Sensoreinheit und/oder die Auswertevorrichtung angeordnet ist. Besonders vorteilhaft bei dieser Ausführungsform ist es, dass die Abdeckkappe auf die bereits erwähnten Arretierungsvorrichtungen mit einstellbarer Federvorspannkraft von Getrieben aufgesetzt werden kann, so dass diese in einfacher Weise zu einer Tasteranordnung gemäß der Erfindung gewandelt werden können. Bei einer besonders günstigen Herstellungsmethode ist die Abdeckkappe als ein Spritzgussteil ausgebildet. Wenn zusätzlich das Gehäuse bzw. der Grundkörper metallisch ausgebildet ist, zeigt sich zudem der Vorteil, dass sämtliche beweglichen Komponenten in einem Metallgehäuse angeordnet sind, wohingegen die elektrischen bzw. elektronischen Komponenten in einem Kunststoffgehäuse platziert sind.

Bei einer bevorzugten Weiterbildung der Erfindung ist die Tasteranordnung als Arretierung der gewählten Schaltstellung und/oder das Tastelement als Arretierbolzen ausgebildet. Die Tasteranordnung dient somit nicht nur dazu, passiv die aktuelle Schaltstellung des Getriebes zu erfassen, sondern zudem, um diese aktiv zu arretieren, insbesondere derart, dass die Arretierung nur unter Überwindung eines Anfangswiderstandes gelöst werden kann.

Es ist dabei besonders bevorzugt, wenn die Tastspitze des Tastelements entweder als massive Spitze, welche beispielsweise konusförmig ausgebildet ist, oder als Tastkugelspitze realisiert ist. Bei einer Ausbildung als Tastkugelspitze weist die Tastspitze eine drehbar gelagerte Tastkugel auf, welche vorzugsweise über eine Mehrzahl von in dem Tastelement gelagerten Wälzkugeln gelagert ist und über einen Abschlussring gesichert ist. Diese Ausführungsform der Tastspitze ermöglicht es dem Tastelement besonders einfach, insbesondere ohne bzw. mit geringerem Reibungswiderstand über die Höhenkodierung der Schaltwelle zu gleiten bzw. rollen.

Ein weiterer Gegenstand der Erfindung betrifft ein Getriebe, welches mehrere Schaltstellungen einnehmen kann, insbesondere ein manuelles oder teilautomatisiertes Getriebe, mit mindestens einer Schaltwelle, welche eine Höhenkodierung zum Auslesen der Schaltstellung aufweist, wobei das Getriebe eine Tasteranordnung nach einem der vorhergehenden Ansprüche bzw. wie es zuvor beschrieben wurde umfasst.

### Kurze Beschreibung der Zeichnungen

Weitere Merkmale, Vorteile und Wirkungen der Erfindung ergeben sich aus der nachfolgenden Beschreibung und den beigefügten Figuren eines bevorzugten Ausführungsbeispiels der Erfindung. Dabei zeigen:
- Figur 1: eine schematische Schnittdarstellung einer Tasteranordnung als ein Ausführungsbeispiel der Erfindung;
- Figur 2: eine teilgeschnittene, schematische dreidimensionale Darstellung der Tasteranordnung in Figur 1;
- Figur 3: die Tasteranordnung in den Figuren 1 und 2 in einer schematischen dreidimensionalen Darstellung schräg von der Seite.

### Detaillierte Beschreibung der Zeichnungen

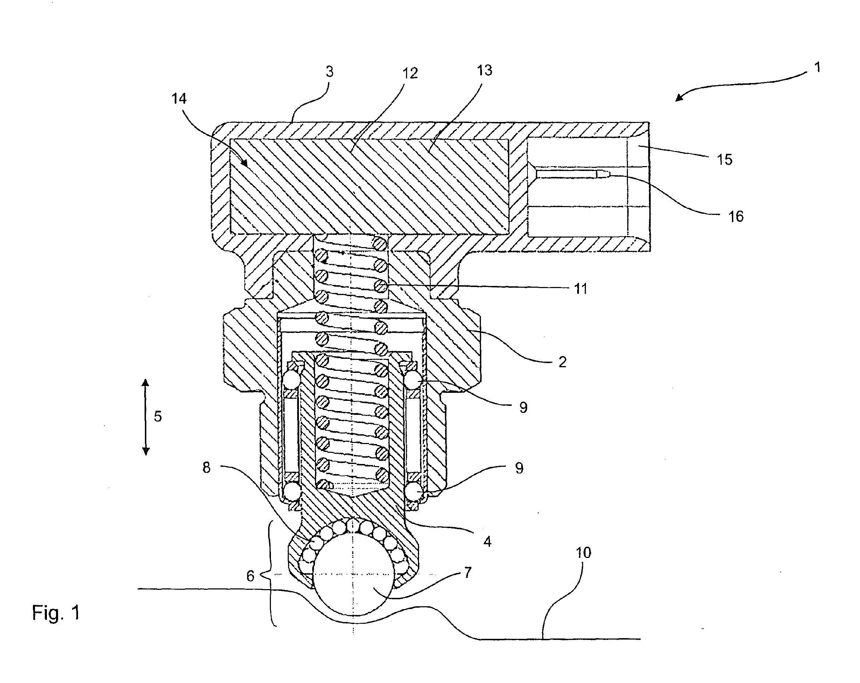

Die Figur 1 zeigt eine Tasteranordnung 1 in einer schematischen Querschnittsdarstellung als ein Ausführungsbeispiel der Erfindung. Die Tasteranordnung 1 umfasst einen Grundkörper 2, welcher beispielsweise aus Metall, insbesondere Edelstahl ausgebildet ist, auf dem eine Abdeckkappe 3 aufgesetzt, insbesondere aufgeschnappt oder aufgeschraubt ist, und in dem ein Tastelement 4 in axialer Richtung gemäß Pfeil 5 verschiebbar gelagert ist.

Das Tastelement 4 weist eine Tastkugelspitze 6 auf, welche eine Tastkugel 7 umfasst, die drehbar über eine Mehrzahl von Wälzkugeln 8 gelagert ist. Zur Sicherung der Tastkugel 7 ist die Tastkugelspitze 6 an ihrem freien Ende umgeformt oder mit einem Sicherungsring versehen. Das Tastelement 4 weist einen zylinderförmigen Körper auf, welcher sich in einen zylinderförmigen Aufnahmeraum in dem Grundkörper 2 erstreckt und dort über zwei Wälzkörperlager 9 verschiebbar gelagert ist.

Im Betrieb wird durch die Tastkugel 7 eine höhenkodierte Kontur einer Schaltwelle 10 abgefahren, wobei die Höhenkodierung entweder längs der Schaltwelle 10, in Umfangsrichtung oder auf einem zusätzlichen Messelement (nicht dargestellt) angeordnet ist und wobei die Höhenkodierung Informationen über die aktuelle Schaltstellung der Schaltwelle 10 repräsentiert. Durch die Höhenkodierung wird das Tastelement 4 in Abhängigkeit von den Schaltstellungen in verschiedene, sich durch die axiale Position gemäß Pfeil 5 unterscheidende Hub-Positionen gesetzt. Um eine ständige, berührende Abtastung der Höhenkodierung der Schaltwelle 10 sicherzustellen, und um die Höhenkodierungsinformation zu übertragen, ist das Tastelement 4 über eine Spiraldruckfeder 11 in Richtung der Schaltwelle 10 vorgespannt. Die Spiraldruckfeder 11 liegt mit ihrem einen freien Ende an einer Auflagefläche in einer Ausnehmung in dem zylinderförmigen Körper des Tastelements 4 und mit ihrem anderen freien Ende an einer Sensoreinheit 12 in der Abdeckkappe 3 an.

Durch die Höhenkodierung nimmt das Tastelement 4 verschiedene Hubpositionen ein, welche auch als Auslesezustände bezeichnet werden können. In Abhängigkeit von der Hub-Position wird die Spiraldruckfeder 11 mehr oder weniger komprimiert, so dass in Abhängigkeit von der Hubposition eine Druckkraft von der Spiraldruckfeder 11 ausgeübt wird, welche gegen die Sensoreinheit 12 in der Abdeckkappe 3 gerichtet ist. Die Sensoreinheit 12 detektiert die beaufschlagte Kraft bzw. den beaufschlagten Druck und wandelt diese in eine elektrische Spannung bzw. in ein elektrisches Spannungssignal um.

Für diesen Zweck umfasst die Sensoreinheit 12 als Messaufnehmer beispielsweise einen Dehnmessstreifen, ein Sensorelement auf Basis der Piezo-Technik, insbesondere einen piezo-elektrischen oder piezo-resistiven Drucksensor, oder einen resistiven Folien-Drucksensor, welcher die beaufschlagte Kraft bzw. den beaufschlagten Druck in eine davon abhängige, insbesondere nahezu direkt proportionale oder direkt proportionale Spannung umwandelt. Insgesamt wird somit die lineare Bewegung des Tastelements 4 bzw. die jeweilige Hub-Position in ein dazu proportionales bzw. nahezu proportionales Spannungssignal umgewandelt.

Dieses Spannungssignal wird einer Auswertevorrichtung 13 zugeführt, die vorzugsweise ebenfalls in der Abdeckkappe 3 integriert ist und die das Spannungssignal als eine Schaltstellung der Schaltwelle 10 interpretiert.

Aufgrund der Spannungsänderung des Ausgangssignals der Sensoreinheit 12 kann somit mit einer geeigneten Auswerteelektronik die Position des Tastelements 4 erkannt, auf die Schaltstellung der Schaltwelle 10 geschlossen und diese Information dem Fahrer oder einem Bordcomputer zugeführt oder eine unmittelbare Reaktion ausgelöst werden, wie z. B. die Ansteuerung eines nachgeschalteten Relais oder ähnlichem, welches eine Last wie z. B. ein Rückfahrlicht schaltet.

Die Abdeckkappe 3 ist vorzugsweise aus Kunststoff hergestellt und umfasst einen Innenraum 14, in dem die Sensoreinheit 12, die Auswertungsvorrichtung 13 und ein Bauteil, z.B. ein Relais oder ein MOSFET, zur Ansteuerung einer elektrischen Last, angeordnet oder vergossen sind, sowie einen Steckerabschnitt 15, welcher Anschlusskontakte 16 zum Anschluss der elektrischen Last, z.B. von Rückfahrleuchten, bereitstellt. Bei alternativen Ausführungsformen kann der Steckerabschnitt 15 eine Schnittstelle für Steuerleitungen zur Verfügung stellen, so dass die Steuerleitungen signaltechnisch mit der Sensoreinheit 12 bzw. der Auswertevorrichtung 13 verbunden sind und Signale an Bauteile zur Schaltung einer Last, an einen Bordcomputer oder an eine Getriebesteuerung weitergeben können.

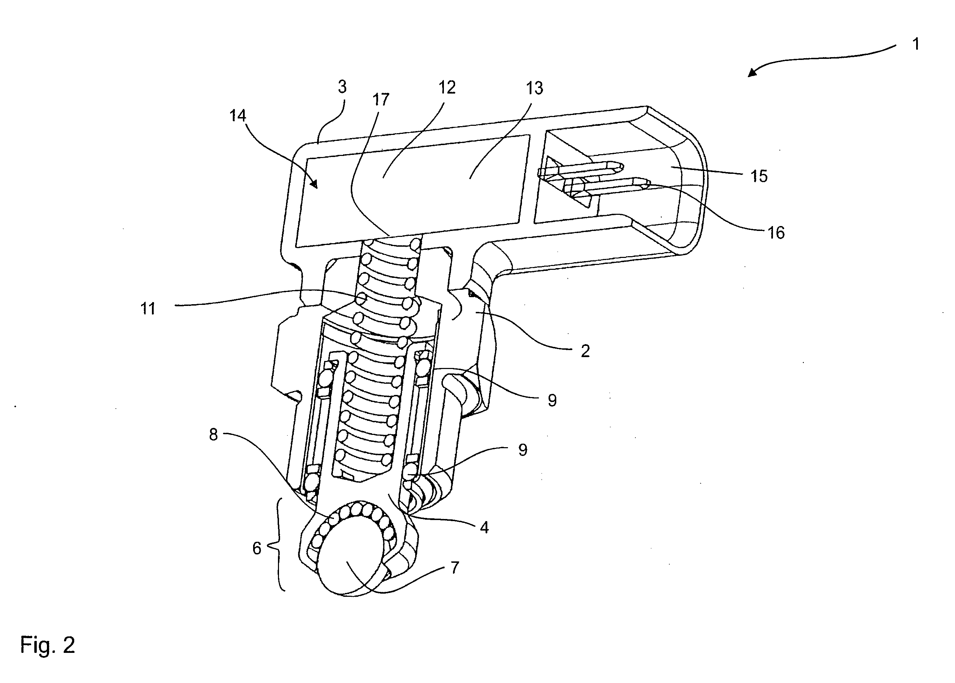

Die Figur 2 zeigt die Tasteranordnung 1 in einer geschnittenen, dreidimensionalen Darstellung, wobei zum einen nochmals gut zu erkennen ist, dass die Sensoreinheit 12 mit dem Tastelement 4 zur Übertragung des Drucksignals ausschließlich über die Spiraldruckfeder 11 verbunden ist. Die Spiraldruckfeder 11 greift an einer Messfläche 17 der Sensoreinheit 12 an, wobei die Messfläche 17 bei Beaufschlagung mit Druck in einem nur sehr geringen Maße, wie z.B. weniger als 1 mm gewölbt wird.

Zum zweiten ist sehr gut zu erkennen, dass das Tastelement 4 bzw. die Tastkugelspitze 6 als ein Arretierbolzen ausgebildet ist, welcher sehr robust ausgeführt ist, um die Schaltwelle 10 in der gewählten Schaltstellung zu arretieren.

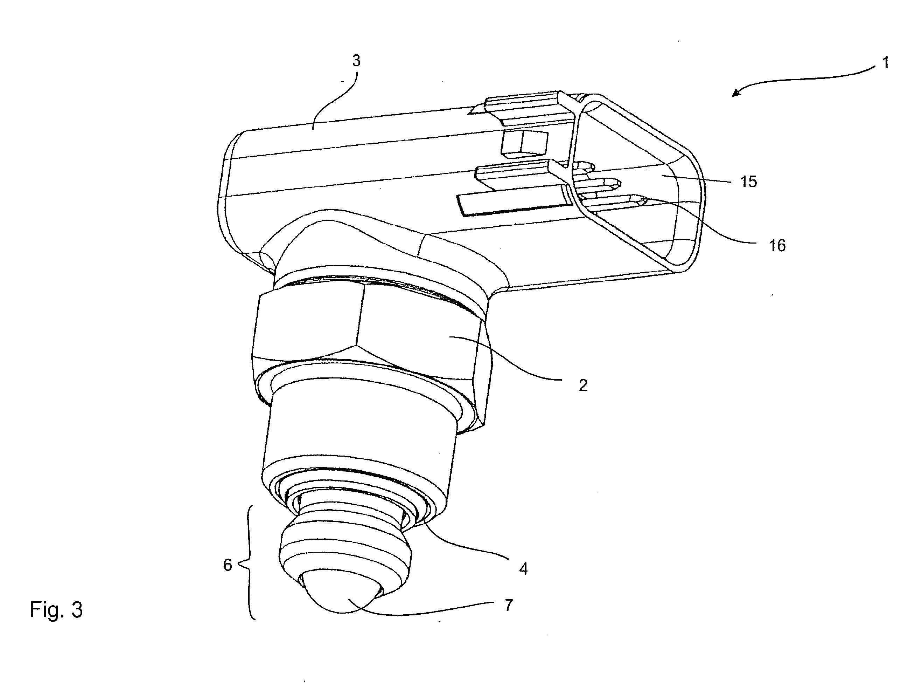

Die Figur 3 zeigt schließlich die Tasteranordnung 1 in einer schematischen dreidimensionalen Darstellung, wobei ein mutterförmiger Flanschansatz an einem Grundkörper 2 zu erkennen ist, mit dem die Tasteranordnung 1 in das Getriebegehäuse einschraubbar ist.

### Bezugszeichenliste

- 1: Tasteranordnung
- 2: Grundkörper
- 3: Abdeckkappe
- 4: Tastelement
- 5: Pfeil
- 6: Tastkugelspitze
- 7: Tastkugel
- 8: Wälzkugel
- 9: Wälzkörperlager
- 10: Schaltwelle
- 11: Spiraldruckfeder
- 12: Sensoreinheit
- 13: Auswertevorrichtung
- 14: Innenraum
- 15: Steckerabschnitt
- 16: Anschlusskontakte
- 17: Messfläche

## Patentansprüche

1. Tasteranordnung (1) zur Erfassung der Schaltstellung eines Getriebes durch Auslesen einer Höhenkodierung einer Schaltwelle (10), mit einem Gehäuse (2), mit einem Tastelement (4), welches in dem Gehäuse (2) in seiner axialen Erstreckungsrichtung (5) verschiebbar angeordnet und/oder ausgebildet ist, wobei eine Tastspitze (6) des Tastelements (4) auf der Schaltwelle (10) bzw. der Höhenkodierung tastend aufliegt und/oder auflegbar ist, so dass das Tastelement (4) entsprechend der Höhenkodierung der Schaltwelle (10) in verschiedene Auslesezustände überführt wird, die sich durch die axiale Lage des Tastelements (4) unterscheiden, und mit einer Sensoreinheit (12) zur Erfassung des Auslesezustands des Tastelements (4), wobei die Sensoreinheit (12) zur Erfassung des Ausleszustands des Tastelements (4) mittels einer Kraft- und/oder Druckmessung ausgebildet ist, **dadurch gekennzeichnet, dass** die Sensoreinheit (12) einen Dehnmessstreifen oder einen auf dem piezoelektrischen Effekt basierenden Messgrößenaufnehmer umfasst

2. Tasteranordnung (1) nach Anspruch 1, **dadurch gekennzeichnet, dass** die Sensoreinheit (12) für eine mehrstufige, quasi-stufenlose und/oder stufenlose Messung ausgebildet ist.

3. Tasteranordnung (1) nach Anspruch 1 oder 2, **dadurch gekennzeichnet, dass** das Tastelement (4) und die Sensoreinheit (12) zur Detektion des Ausleszustands über ein elastisches Übertragungsmittel (11) miteinander verkoppelt sind.

4. Tasteranordnung (1) nach Anspruch 3, **dadurch gekennzeichnet, dass** das elastische Übertragungsmittel eine Feder (11), insbesondere eine Druckfeder ist.

5. Tasteranordnung (1) nach Anspruch 4, **dadurch gekennzeichnet, dass** sich die Feder (11) mit dem einen freien Ende an dem Tastelement (4) und mit dem anderen freien Ende an der Sensoreinheit (12), insbesondere einer Messfläche (17) der Sensoreinheit (12) abstützt.

6. Tasteranordnung (1) nach einem der Ansprüche 1 oder 2, **dadurch gekennzeichnet, dass** das Tastelement (4) und die Sensoreinheit (12) zur Detektion des Auslesezustands starr miteinander verkoppelt sind.

7. Tasteranordnung (1) nach einem der vorhergehenden Ansprüche, **gekennzeichnet durch** eine Auswertevorrichtung (13), welche ausgebildet ist, anhand der Kraft- und/oder Druckmessung die Schaltstellung des Getriebes zu erkennen.

8. Tasteranordnung (1) nach Anspruch 7, **dadurch gekennzeichnet, dass** die Auswertevorrichtung (13) eine Schnittstelle (16) zur Ansteuerung eines Bauteils zur Schaltung einer elektrischen Last aufweist.

9. Tasteranordnung (1) nach einem der vorhergehenden Ansprüche, **dadurch gekennzeichnet, dass** das Gehäuse als ein in ein Getriebegehäuse einschraubbarer oder einpressbarer Grundkörper (2) ausgebildet ist.

10. Tasteranordnung (1) nach einem der vorhergehenden Ansprüche, **gekennzeichnet durch** eine Abdeckkappe (3), welche auf dem Gehäuse bzw. dem Grundkörper (2) befestigbar ist, wobei in der Abdeckkappe (3) die Sensoreinheit (12) und/oder die Auswertevorrichtung (13) angeordnet ist.

11. Tasteranordnung (1) nach Anspruch 10, **dadurch gekennzeichnet, dass** die Abdeckkappe (3) als ein Spritzgussteil ausgebildet ist.

12. Tasteranordnung (1) nach einem der vorhergehenden Ansprüche, **dadurch gekennzeichnet, dass** die Tasteranordnung (1) als Arretierung der gewählten Schaltstellung und/oder das Tastelement (4) als Arretierbolzen ausgebildet ist bzw. sind.

13. Tasteranordnung (1) nach einem der vorhergehenden Ansprüche, **dadurch gekennzeichnet, dass** die Tastspitze (6) als massive Spitze oder Tastkugelspitze mit einer Tastkugel (7) ausgebildet ist.

14. Getriebe mit mehreren Schaltstellungen und mindestens einer Schaltwelle (10), welche eine Höhenkodierung zum Auslesen der Schaltstellung aufweist, **dadurch gekennzeichnet, dass** das Getriebe eine Tasteranordnung (1) nach einem der vorhergehenden Ansprüche umfasst.

## Claims

1. Sensor arrangement (1) for detecting the gear position of a transmission by reading out height encoding of a shifting shaft (10), having a housing (2), having a sensing element (4) which is arranged in the housing (2) and/or designed such that it can be displaced in its direction (5) of axial extent, wherein a sensing tip (6) of the sensing element (4) rests and/or can be rested on the shifting shaft (10) or the height encoding means in a sensing fashion with the result that the sensing element (4) is transferred into different reading-out states in accordance with the height encoding of the shifting shaft (10), which reading-out states differ in the axial position of the sensing element (4), and having a sensing unit (12) for detecting the reading-out state of the sensing element (4), wherein the sensor unit (12) is designed to detect the reading-out state of the sensing element (4) by means of a measurement of force and/or pressure, **characterized in that** the sensor unit (12) comprises a strain measuring gauge or a measuring variable pickup which is based on the piezo-electric effect.

2. Sensor arrangement (1) according to Claim 1, **characterized in that** the sensor unit (12) is designed for multi-stage, quasi-continuous and/or continuous measurement.

3. Sensor arrangement (1) according to Claim 1 or 2, **characterized in that** the sensing element (4) and the sensor unit (12) are coupled to one another via an elastic transmission means (11) in order to detect the reading-out state.

4. Sensor arrangement (1) according to Claim 3, **characterized in that** the elastic transmission means is a spring (11), in particular a compression spring.

5. Sensor arrangement (1) according to Claim 4, **characterized in that** the spring (11) is supported by the one free end on the sensor element (4) and by the other free end on the sensor unit (12), in particular a measuring surface (17) of the sensor unit (12).

6. Sensor arrangement (1) according to one of Claims 1 or 2, **characterized in that** the sensing element (4) and the sensor unit (12) are rigidly coupled to one another in order to detect the reading-out state.

7. Sensor arrangement (1) according to one of the preceding claims, **characterized by** an evaluation device (13) which is designed to detect the shift position of the transmission on the basis of the measurement of force and/or pressure.

8. Sensor arrangement (1) according to Claim 7, **characterized in that** the evaluation device (13) has an interface (16) for actuating a component for switching an electric load.

9. Sensor arrangement (1) according to one of the preceding claims, **characterized in that** the housing is embodied as a base body (2) which can be screwed or pressed into a transmission housing.

10. Sensor arrangement (1) according to one of the preceding claims, **characterized in that** a cover cap (3) which can be attached to the housing or the base body (2), wherein the sensor unit (12) and/or the evaluation device (13) is/are arranged in the cover cap (3).

11. Sensor arrangement (1) according to Claim 10, **characterized in that** the cover cap (3) is embodied as an injection moulded part.

12. Sensor arrangement (1) according to one of the preceding claims, **characterized in that** the sensor arrangement (1) is embodied as a locking means for the selected shift position and/or the sensing element (4) is embodied as a locking bolt.

13. Sensor arrangement (1) according to one of the preceding claims, **characterized in that** the sensing tip (6) is embodied as a solid tip or a sensing ball tip with a sensing ball (7).

14. Transmission having a plurality of shift positions and at least one shift shaft (10) which has height encoding for reading out the shift position, **characterized in that** the transmission comprises a sensor arrangement (1) according to one of the preceding claims.

## Revendications

1. Ensemble de palpage (1) destiné à détecter la position de branchement d'une transmission par lecture d'un code de hauteur sur un arbre de raccordement (10), et présentant un boîtier (2), un élément de palpage (4) disposé et/ou configuré pour pouvoir se déplacer dans le boîtier (2) dans la direction (5) de son extension axiale,
une pointe de palpage (6) de l'élément de palpage (4) reposant ou pouvant être placée en contact sur l'arbre de raccordement (10) ou le codage en hauteur de telle sorte que l'élément de palpage (4) soit amené en différentes situations de lecture en correspondance au codage en hauteur qui se distingue par la position axiale de l'élément de palpage (4) en correspondance au codage en hauteur de l'arbre de raccordement (10) et
une unité de détection (12) qui détecte l'état de lecture de l'élément de palpage (4),
l'unité de détection (12) étant configurée pour saisir l'état de lecture de l'élément de palpage (4) au moyen d'une mesure de force et/ou d'une mesure de pression,
**caractérisé en ce que**
l'unité de détection (12) comporte un ruban de mesure d'allongement ou un enregistreur de grandeurs de mesure basé sur l'effet piézoélectrique.

2. Ensemble de palpage (1) selon la revendication 1, **caractérisé en ce que** l'unité de détection (12) est configurée pour effectuer une mesure en plusieurs étapes, une mesure quasi continue et/ou une mesure continue.

3. Ensemble de palpage (1) selon les revendications 1 ou 2, **caractérisé en ce que** l'élément de palpage (4) et l'unité de détection (12) sont raccordées l'une à l'autre pour détecter la situation de lecture par l'intermédiaire d'un moyen élastique de transfert (11).

4. Ensemble de palpage (1) selon la revendication 3, **caractérisé en ce que** le moyen élastique de transfert et un ressort (11) et en particulier un ressort de compression.

5. Ensemble de palpage (1) selon la revendication 4, **caractérisé en ce que** le ressort (11) s'appuie par une de ses extrémités libres sur l'élément de palpage (4) par son autre extrémité libre sur l'unité de détection (12) et en particulier sur une surface de mesure (17) de l'unité de détection (12).

6. Ensemble de palpage (1) selon l'une des revendications 1 ou 2, **caractérisé en ce que** l'élément de palpage (4) et l'unité de détection (12) sont raccordés rigidement l'un à l'autre pour détecter la situation de lecture.

7. Ensemble de palpage (1) selon l'une des revendications précédentes, **caractérisé par** un dispositif d'évaluation (13) configuré pour reconnaître la position de raccordement de la transmission à l'aide de la mesure de force et/ou de la mesure de pression.

8. Ensemble de palpage (1) selon la revendication 7, **caractérisé en ce que** le dispositif d'évaluation (13) présente une interface (16) permettant la commande d'un composant de raccordement d'une charge électrique.

9. Ensemble de palpage (1) selon l'une des revendications précédentes, **caractérisé en ce que** le boîtier est configuré comme corps de base (2) apte à être vissé ou enfoncé dans un carter de transmission.

10. Ensemble de palpage (1) selon l'une des revendications précédentes, **caractérisé par** un capot de recouvrement (3) qui peut être fixé sur le boîtier ou sur le corps de base (2), l'unité de détection (12) et/ou le dispositif d'évaluation (13) étant disposés dans le capot de recouvrement (3).

11. Ensemble de palpage (1) selon la revendication 10, **caractérisé en ce que** le capot de recouvrement (3) est configuré comme pièce moulée par injection.

12. Ensemble de palpage (1) selon l'une des revendications précédentes, **caractérisé en ce que** l'ensemble de palpage (1) est configuré comme blocage de la position de raccordement sélectionnée et/ou **en ce que** l'élément de palpage (4) est configuré comme goujon de blocage.

13. Ensemble de palpage (1) selon l'une des revendications précédentes, **caractérisé en ce que** la pointe de palpage (6) est configurée comme pointe massive ou comme pointe dotée d'une bille de palpage (7).

14. Transmission présentant plusieurs positions de raccordement et au moins un arbre de raccordement (10) qui présente un codage en hauteur permettant de lire la position de raccordement, **caractérisée en ce que** la transmission comporte un ensemble de palpage (1) selon l'une des revendications précédentes.
